Europäisches Patentamt

**European Patent Office**

Office européen des brevets

(11) Publication number: **0 082 471**
**B1**

(12) **EUROPEAN PATENT SPECIFICATION**

(45) Date of publication of patent specification: **24.08.88**

(51) Int. Cl.⁴: **H 03 K 17/66, H 03 K 17/74**

(21) Application number: **82111627.4**

(22) Date of filing: **15.12.82**

(54) **Diode driver circuit.**

(30) Priority: **18.12.81 JP 205950/81**

(43) Date of publication of application:
**29.06.83 Bulletin 83/26**

(45) Publication of the grant of the patent:
**24.08.88 Bulletin 88/34**

(84) Designated Contracting States:
**DE FR IT**

(56) References cited:
**FR-A-2 098 418**
**US-A-3 828 345**
**US-A-3 905 037**
**US-A-3 922 570**
**US-A-4 196 381**

(73) Proprietor: **NEC CORPORATION**
**33-1, Shiba 5-chome, Minato-ku**
**Tokyo 108 (JP)**

(72) Inventor: **Fujita, Toshio**
**c/o NEC CORPORATION, 33-1, Shiba 5-chome**
**Minato-ku, Tokyo 108 (JP)**

(74) Representative: **Vossius & Partner**
**Siebertstrasse 4 P.O. Box 86 07 67**
**D-8000 München 86 (DE)**

Courier Press, Leamington Spa, England.

# Description

The present invention relates to an improvement of diode driver circuits for driving P-I-N diodes, Schottky diodes or the like for use in a phase modulator, a diode switch or the like, and more particularly to a high-speed diode driver circuit of low power consumption.

A P-I-N diode having high reverse voltage and low forward impedance is used in a high-power phase modulator, a diode switch and the like. However, since the minority carriers or charges are accumulated in the I layer of a P-I-N diode during the period of forward bias, the diode deteriorates in high-speed response. For this reason, a high-speed P-I-N diode driver circuit requires a function to cancel the accumulated carrier in a short period of time when the diode is biassed from the forward to the reverse direction. Conversely, when the diode is biassed from the reverse to the forward direction, the charges accumulated in the junction barrier during the period of reverse bias have to be quickly erased, and this function is also required by a high-speed P-I-N diode driver circuit.

One of the conventional driver circuits having these functions is disclosed in the US—A—3 922 570. In this circuit, a constant current circuit and a low impedance circuit are connected to a P-I-N diode. When the diode is biassed in the forward direction, the transistor of the low-impedance circuit is cut off and a constant bias current is supplied from the constant current circuit. When the P-I-N diode is switched or biassed from the forward to the reverse direction, a large current is supplied from the low impedance circuit to the P-I-N diode to discharge the charges accumulated therein in a short period of time and thereby to achieve high speed. This circuit, though excelling in speed, requires a large current to be supplied to the switching transistor because the current to discharge the charges in the junction barrier is fed to the switching transistor by way of a diode connected to the base and the emitter of the transistor of the low impedance circuit, and therefore does not permit ready reduction of the power consumption and the hardware size.

FR—A—2 098 418 discloses a memory selection circuit including a discharge circuit which comprises a transistor, a capacitor and a resistor. The discharge circuit discharges the charge of a second transistor during a short period beginning with the turning off of the second transistor.

It is an object of the present invention to provide a high-speed diode driver circuit of low power consumption, which can be readily reduced in size.

This object is achieved by the diode driver circuit according to claim 1.

The invention will be described hereunder with reference to the accompanying drawings, wherein:

Fig. 1 illustrates one embodiment of the diode driver circuit according to the invention; and

Figs. 2A to E are time charts showing the voltage or current waveforms at points A to E, respectively, of Fig. 1.

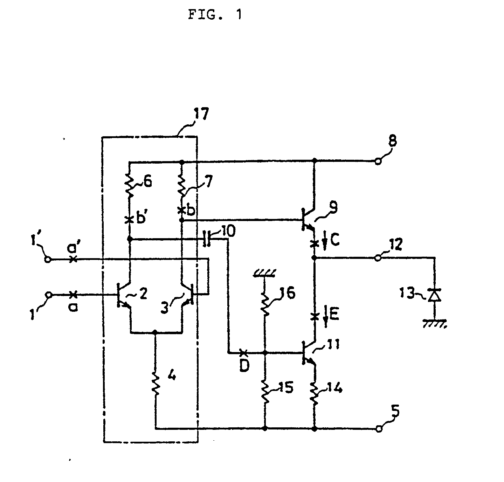

The diode driver circuit of the present invention shown in Fig. 1 is, for example, used for the phase modulator illustrated in Fig. 1 of US—A—3 922 570. In Fig. 1, an input terminal 1 is connected to the base of a transistor 2, and another input terminal 1' is connected to the base of another transistor 3. To the input terminals 1 and 1' are fed signals reverse in phase to each other. The emitters of the transistors 2 and 3 are connected to a resistor 4. The other side of the resistor 4 is connected to a negative power supply terminal 5. The collectors of the transistors 2 and 3 are connected to a positive power supply terminal 8 by way of resistors 6 and 7, respectively. The collector of the transistor 3 is further connected to the base of a transistor 9, and that of the transistor 2 to the base of a transistor 11 by way of a capacitor 10. The collector of the transistor 9 is connected to the positive power supply terminal 8, and the emitter thereof to the collector of the transistor 11 and also to the cathode of a P-I-N diode 13 by way of an output terminal 12. The emitter of the transistor 11 is connected to the negative power supply terminal 5 by way of a resistor 14. The base of the transistor 11 is connected to the negative power supply terminal 5 by way of a resistor 15 and also grounded by way of a resistor 16. The anode of the P-I-N diode 13 is grounded.

In this circuitry, driving signals fed to the signal input terminals 1 and 1' are amplified by a differential pulse amplifier 17 consisting of the transistors 2 and 3 and the resistors 6, 7 and 4. One side of the output of the differential pulse amplifier 17 is taken from the collector of the transistor 3, and fed to the base of the transistor 9. The other, the complementary side of the output of the differential pulse amplifier 17 is taken from the collector of the transistor 2, and fed to the base of the transistor 11 by way of the capacitor 10. The transistor 9 operates as a low impedance circuit, and the transistor 11, a suitable potential being given to its base, operates as a constant current circuit.

If the low level output voltage of the differential pulse amplifier 17 is set to be slightly negative when the P-I-N diode is forward-biassed, the transistor 9 will be cut off and the current supplied from the transistor 11 will wholly flow to the P-I-N diode 13, to which a constant current (1 mA for instance) in the forward direction will flow at normal times.

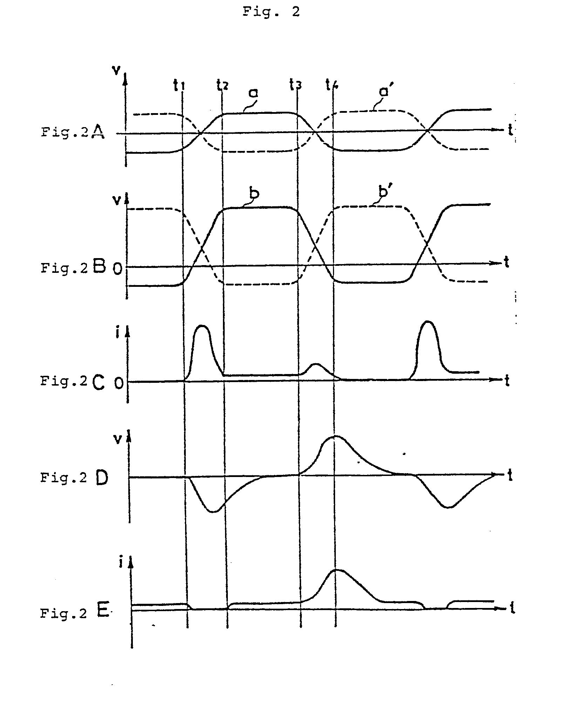

This aspect will be described in further detail below. Fig. 2A shows the voltage waveforms to the pulses fed to the input terminals 1 and 1', a solid line *a* representing the pulse given to the input terminal 1 and a dotted line *a'*, that given to the input terminal 1'. These pulses *a* and *a'* are amplified by the differential pulse amplifier 17 as illustrated in Fig. 2B, where a solid line *b* represents the output voltage at the collector of the transistor 3 and a dotted line *b'*, that at the collector of the transistor 2. Before time point $t_1$ in Fig. 2B, charges proportional to the forward current are accumulated in the P-I-N diode 13. A period from time $t_1$ to time $t_2$ is the transitional period during which the P-I-N diode is biassed in direction from forward to reverse. During this period, the base voltage of the transistor 9 is switched from negative to positive to turn "on" the transistor 9 and, as shown in Fig. 2C, a large current (100 mA for instance) flows so that the charge of the P-I-N diode 13 is quickly discharged to turn "off" the P-I-N diode 13.

Meanwhile, to the base of the transistor 11 is supplied a voltage represented by *b'* in Fig. 2B by way of the capacitor 10, whose value is so selected that the voltage fed to the base of the transistor 11 takes a differential waveform as shown in Fig. 2D. In this instance, the current waveform of the transistor 11 is like what is illustrated in Fig. 2E. During the period from time $t_1$ to time $t_2$, the transistor 11 is substantially cut off to accelerate the discharging of the P-I-N diode 13.

Next, a period from time $t_3$ to time $t_4$ is the transitional period during which the P-I-N diode 13 is switched or biassed in direction from reverse to forward. The emitter voltage of the transistor 9 changes from positive to negative along with the variation of the base voltage thereof, and the transistor 9 is cut off at time $t_4$. Meanwhile, the transistor 11 supplies a large current from time $t_3$ to time $t_4$ and a short period of time thereafter to discharge the charge of the P-I-N diode 13 attributable to the junction barrier capacitance. At the same time, the charge in the I layer of the P-I-N diode 13 is quickly brought to its steady state.

In this manner, the charge within the P-I-N diode 13 is substantially constant irrespective of the length of time from the point of time $t_4$ to the next change in direction from forward to reverse. Therefore the current supplied from the transistor 9 to the P-I-N diode 13 when the biassing direction is from forward to reverse remains constant, resulting in a switching performance susceptible to little jitter.

Furthermore, it is sufficient for the outer amplitude of the differential pulse amplifier 17 to be only slightly, not substantially, greater than that of the reverse voltage fed to the P-I-N diode 13, and currents flow to the transistors 9 and 11 virtually solely during the transitional periods of switching, so that the power consumption is remarkably small. The current of the P-I-N diode 13 in the forward direction in its steady state is normally smaller than the transitional currents at the switching points.

As hitherto described, the present invention can provide a high-speed P-I-N diode driver circuit of low power consumption, which can be readily reduced in size.

### Claims

1. A diode driver circuit comprising:
a) switching means (17) responsive to a modulating input signal for providing a pair of mutually complementary first and second outputs (b, b'),

b) modulating diode means (13) for causing microwave modulation,

c) low impedance circuit means (9) connected to said switching means (17) and the cathode of said diode means (13) for feeding a reverse voltage to said diode means (13) in response to said first output (b) of said switching means (17), and

d) constant current circuit means (11, 14 to 16) connected to the cathode of said diode means (13) for supplying a constant current in the forward direction to said diode means (13) in its steady state,

characterized in that said constant current circuit means (11, 14 to 16) is controllable in response to said second output (b') of said switching means (17) for supplying an excess current over the constant current for a short period from the time said diode means (13) is biassed from the reverse to the forward direction.

2. The diode driver circuit according to claim 1, characterized in that a capacitor (10) is connected between said second output (b') of said switching means (17) and said constant current circuit means (11, 14 to 16).

### Patentansprüche

1. Dioden-Treiberschaltung mit
a) einer auf ein Modulations-Eingangssignal ansprechenden Schalteinrichtung (17) zum Liefern eines Paars gegenseitig komplementärer erster und zweiter Ausgänge (b, b'),

b) einer Modulations-Diodeneinrichtung (13) zur Mikrowellenmodulation,

c) einer Niederimpedanz-Schaltkreiseinrichtung (9), die mit der Schalteinrichtung (17) und der Kathode der Diodeneinrichtung (13) verbunden ist, um als Antwort auf den ersten Ausgang (b) der Schalteinrichtung (17) der Diodeneinrichtung (13) eine Gegenspannung zuzuführen, und

d) einer mit der Kathode der Diodeneinrichtung (13) verbundenen Konstantstrom-Schaltkreiseinrichtung (11, 14 bis 16) zum Liefern eines konstanten Stroms in der Vorwärtsrichtung der Diodeneinrichtung (13) in deren stabilem Zustand,

dadurch gekennzeichnet, daß die Konstantstrom-Schaltkreiseinrichtung (11, 14 bis 16) in Abhängigkeit von dem zweiten Ausgang (b') der Schalteinrichtung (17) steuerbar ist, um für eine kurze Zeitdauer von dem Zeitpunkt an, an dem die Diodeneinrichtung (13) von der Rückwärtsrichtung in die Vorwärtsrichtung vorgespannt wird, einen den konstanten Strom Übersteigenden Überschußstrom zu liefern.

2. Dioden-Treiberschaltung nach Anspruch 1, dadurch gekennzeichnet, daß ein Kondensator (10) zwischen dem zweiten Ausgang (b') der Schalteinrichtung (17) und der Konstantstrom-Schaltkreiseinrichtung (11, 14 bis 16) verbunden ist.

5

0 082 471

**Revendications**

1. Circuit d'attaque pour diode, comprenant:
a) un moyen de commutation (17) répondant à un signal d'entrée de modulation pour fournir une paire de première et seconde sorties mutuellement complémentaires (b, b'),
b) un moyen de diode de modulation (13) pour provoquer la modulation de micro-ondes,
c) un moyen de circuit à faible impédance (9) connecté au moyen de commutation (17) et à la cathode du moyen de diode (13) pour appliquer une tension inverse au moyen de diode (13) en réponse à la première sortie (b) du moyen de commutation (17), et
d) un moyen de circuit à courant constant (11, 14 à 16) connecté à la cathode du moyen de diode (13) pour fournir un courant constant dans la direction directe au moyen de diode (13) à son état constant,
caractérisé en ce que le moyen de circuit à courant constant (11, 14 à 16) peut être commandé en réponse à la seconde sortie (b') du moyen de commutation (17) afin de fournir un courant, dépassant le courant constant pendant un court laps de temps s'écoulant entre le moment où le moyen de diode (13) est polarisé pour passer du sens inverse au sens direct.

2. Circuit d'attaque pour diode selon la revendication 1, caractérisé en ce qu'un condensateur (10) est connecté entre la second sortie (b') du moyen de commutation (17) et le moyen de circuit à courant constant (11, 14 à 16).

FIG. 1

Fig. 2

Fig.2A

Fig.2B

Fig.2C

Fig.2D

Fig.2E